(19) Europäisches Patentamt
European Patent Office
Office européen des brevets

(11) **EP 0 692 822 A1**

(12) **EUROPÄISCHE PATENTANMELDUNG**

(43) Veröffentlichungstag:
17.01.1996 Patentblatt 1996/03

(51) Int. Cl.⁶: **H01L 23/40**

(21) Anmeldenummer: 95250166.6

(22) Anmeldetag: 06.07.1995

(84) Benannte Vertragsstaaten:
**DE FR GB**

(30) Priorität: **16.07.1994 DE 4426646**

(71) Anmelder: **AEG Schienenfahrzeuge GmbH**
**D-16761 Hennigsdorf (DE)**

(72) Erfinder:
• **Feldhusen, Jörg, Dr.-Ing.**
**D-41352 Kleinenbroich (DE)**

• **Schöntag, Hartmut, Dipl.-Ing.**
**D-13627 Berlin (DE)**
• **Loeck, Christopher**
**D-14055 Berlin (DE)**
• **von der Heydt, Bernd**
**D-14195 Berlin (DE)**

(74) Vertreter: **Rüthning, Wolfgang, Dipl.-Ing.**
**D-60596 Frankfurt (DE)**

(54) **Spannvorrichtung für Scheibenzellenhalbleiter**

(57)　Die Erfindung betrifft eine Spannvorrichtung für Scheibenzellenhalbleiter, insbesondere Scheibenzellen-Leistungshalbleiter, bei der ein oder mehrere Halbleiter, speziell bei Stapelaufbauten mit anderen Komponenten, zwischen eine Grundplatte und eine Druckplatte eingespannt werden, wobei die Klemmkraft zwischen Grundplatte und Druckplatte insbesondere über mehrere an der Peripherie der Platten angeordnete Stehbolzen mit endseitiger Verschraubung erzeugt und über zwischengeschaltete mitverspannte federnde Elemente der eigentliche Kontaktdruck bewirkt wird. Es soll eine einfache, preiswerte und robuste Spannvorrichtung geschaffen werden, mit der ein definiertes Aufbringen der Kraft möglich ist, die auch jederzeit im Betrieb einfach kontrollierbar bleibt. Eine gleichmäßige Krafteinleitung soll auch bei unsorgfältiger Montage oder größeren Fertigungstoleranzen gewährleistet bleiben. Dazu wird erfindungsgemäß vorgeschlagen, daß die Halbleiter direkt zwischen Grundplatte (1) und Druckplatte (2) angeordnet sind und die Kraftübertragung von der Grundplatte (1) über die Stehbolzen (5) zur Druckplatte (2) mittels einer zusätzlichen Spannplatte (6) erfolgt, die von den Stehbolzen (5) durchdrungen wird und einen in Kraftwirkungsrichtung axial verschiebbaren Stempel (7) aufweist, der sich einerseits über die federnden Elemente gegen die Spannplatte (6) abstützt und andererseits die über die Bolzenverschraubung (5/9) ausgeübte Kraft an die Druckplatte (2) weitergibt.

FIG.4

**Beschreibung**

Die Erfindung betrifft eine Spannvorrichtung für Scheibenzellenhalbleiter, insbesondere Scheibenzellen-Leistungshalbleiter, wie sie im Oberbegriff des Anspruches 1 näher definiert ist.

Zur betriebssicheren Montage von Leistungshalbleitern und deren elektrischen Zuleitungen bedarf es aufgrund der hohen zu übertragenden Ströme einer Spannvorrichtung, die durch Zusammenpressen der stromdurchflossenen Komponenten eine sichere Stromübertragung gewährleistet.

Es ist bei den auftretenden hohen Strömen von bis zu 3000 A bei Spannungen bis zu 4500 V durch Aufbringen einer axialen Anpreßkraft sicherzustellen, daß dem Strom der komplette elektrisch leitende Querschnitt des Leistungshalbleiters und der sich beruhrenden Flächen benachbarter Komponenten zur Verfügung steht. Ist diese Bedingung nicht erfüllt und der Stromdurchlaß nur punktuell möglich, bedeutet dies einen erhöhten ohm'schen Widerstand und eine damit verbundene unzulässige Erwärmung, die zu einer Zerstörung der Komponenten, vor allen der teueren Leistungshalbleiter führen kann.

Um die Stromtragfähigkeit der Leistungshalbleiter und der elektrischen Verbindungen zu erreichen, werden alle zur Erfüllung einer bestimmten Funktion notwendigen Komponenten im allgemeinen zu einer Baugruppe zusammengefaßt. Die Baugruppe bildet dann ein Paket aus gestapelten Leistungshalbleitern, elektrischen Zuleitungen (Kupferschienen), Isolierzellen und Kühlkörpern, das von einer solchen Spannvorrichtung zur Aufbringung der erforderlichen axialen Anpreßkraft zusammengehalten wird.

Bei gebräuchlichen bekannten Konstruktionen besteht die Spannvorrichtung meistens aus drei in Form eines gleichseitigen Dreiecks auf einem Kühlkörper angeordneten Stehbolzen, in deren Mitte sich die Komponenten befinden, die ihrerseits von einer ebenfalls dreieckigen Druckplatte mit Hilfe von auf die Stehbolzen geschraubten Muttern zusammengepreßt werden, wobei bei größeren Ausführungen Spannkräfte von 45 kN erreicht werden.

Das Aufbringen einer definierten Kraft wird bei den meisten derartigen Konstruktionen durch definiertes Anziehen der Muttern mit Hilfe eines Drehmomentenschlüssels erreicht. Die so erzeugte Kraft wird dann mit Hilfe einer festen Druckplatte mit eingebrachter Feder bzw. einer federnden Druckplatte auf die Komponenten übertragen. Bei dieser Vorgehensweise läßt sich die aufzubringende Kraft und somit auch das entsprechende notwendige Anzugsdrehmoment nur im voraus theoretisch bestimmen. Bei der Montage läßt sich zwar das Anzugsmoment kontrollieren, nicht jedoch die daraus resultierende tatsächliche axiale Anpreßkraft. Bei der Vorausberechnung des notwendigen Drehmomentes muß berücksichtigt werden, daß sämtliche Bestandteile der Spannvorrichtung, einschließlich der zu spannenden Komponenten, ein komplexes Gebilde parallel und in Reihe geschalteter Federn darstellt, deren einzelne Federnkennlinien bekannt sein müssen. Werden einzelne Komponenten durch andersartige ersetzt (z.B. eine Isolierzelle durch einen Leistungshalbleiter), verändert sich das ganze System. Besonders problematisch sind die sehr schwer abschätzbaren Reibungsverluste innerhalb der Befestigungselemente, die je nach Fertigungsqualität und Schmierung erheblich differieren können. Setzungserscheinungen innerhalb des Gesamtsystems sind nicht erkennbar, so daß es in Verbindung mit den anderen Unzulänglichkeiten derartiger Spannvorrichtungen kaum möglich ist, so eine definierte Kraft aufzubringen bzw. zu halten. Auch bei ungleichmäßig stark angezogenen Muttern auf den Stehbolzen sollte die Krafteinleitung über den gesamten Querschnitt gleichmäßig erfolgen. Die meisten Konstruktionen vermeiden deshalb ebene Druckplatten, die schon bei leichter Schieflage die Kraft extrem einseitig übertragen würden.

Es ist schon vorgeschlagen worden, eine ausreichende Kraft mit Hilfe eines elektrischen Anzeigesystems zu signalisieren. Diese Lösung ist aber aufwendig und nicht optimal gegen die nicht auszuschließende Ausfall- Möglichkeit anzusehen, außerdem bedarf diese Lösung einer zusätzlichen Energieversorgung.

Durch Verwendung einer nach unten sphärisch gewölbten Druckplatte, die sich auf einer ausreichend biegesteifen Grundplatte zentrisch abstützt und bei Schieflage auf dieser abrollen kann, ist es möglich die Krafteinleitung zu vergleichmäßigen. Nachteilig bei dieser Lösung ist der relativ große Radius der Krümmung, der beim Abrollen zu einer großen Exzentrizität führt und somit einer zentrischen und damit gleichmäßigen Krafteinleitung entgegenwirkt.

Ähnlich ungünstig stellt sich auch die Verwendung einer Kugelkalotte anstelle einer Ebene, durch die das schädliche Herauswandern der sphärischen Wölbung bzw. Kugel aus einer zentrischen Lage über eine Zwangsführung vermieden werden werden soll. Ein reibungsarmes Abrollen wird dabei durch ein reibungsintensives Gleiten des Kugelkörpers in der Kugelkalotte ersetzt. Der Einsatz ist kritisch. Schlecht gewählte Hebelverhältnisse und unzureichende Fertigungsqualität kann bei den auftretenden erheblichen Spannkräften zu eine Blockieren der Kugelkalotte mit unerwünschten Folgen führen. Darüberhinaus ist die Herstellung einsatzfähiger Kugelkalotten mit entsprechender Oberflächengüte extrem kostenintensiv.

Insgesamt erfüllen die derzeit im Einsatz befindlichen Spannvorrichtungen die an sie gestellten Anforderungen hinsichtlich definiert aufgebrachter und gleichmäßig eingeleiteter Kraft nur unzureichend, was eine nur bedingt gute Stromführung und somit auch eine häufige Beschädigung der Leistungshalbleiter zur Folge hat. Aufgabe der Erfindung ist es, hier Abhilfe zu schaffen.

Es gilt, eine einfache, preiswerte und robuste Spannvorrichtung für Scheibenzellenhalbleiter zu schaffen, mit der ein definiertes Aufbringen der Kraft, die jederzeit auch im Betrieb kontrollierbar sein soll und auch eine gleichmäßige Krafteinleitung --bei unsorgfältiger Montage und/oder größeren Herstelltoleranzen der Einzelteile-- ermöglicht wird.

Diese Aufgabe wird gemäß den kennzeichnenden Merkmalen des Anspruches 1 gelöst. Vorteilhafte Ausgestaltungen der Erfindung sind den Unteransprüchen entnehmbar.

Durch die Erfindung ergibt sich eine Entkopplung der krafterzeugenden Komponenten vom Gesamtsystem und eine einfache und zuverlässige Kontrolle der aufgebrachten Kraft über ein mit gebräuchlichen Meßmitteln auswertbares Wegmeßsystem.

Anhand der Figuren der Zeichnung wird die Erfindung im nachstehenden näher erläutert.

Es zeigen:

Fig. 1    ein Funktionsprinzip der Spannvorrichtung

Fig. 2    die Ansicht einer Spannplatteneinheit im Schnitt

Fig. 3    Draufsicht auf die Spannplatteneinheit nach Fig. 2

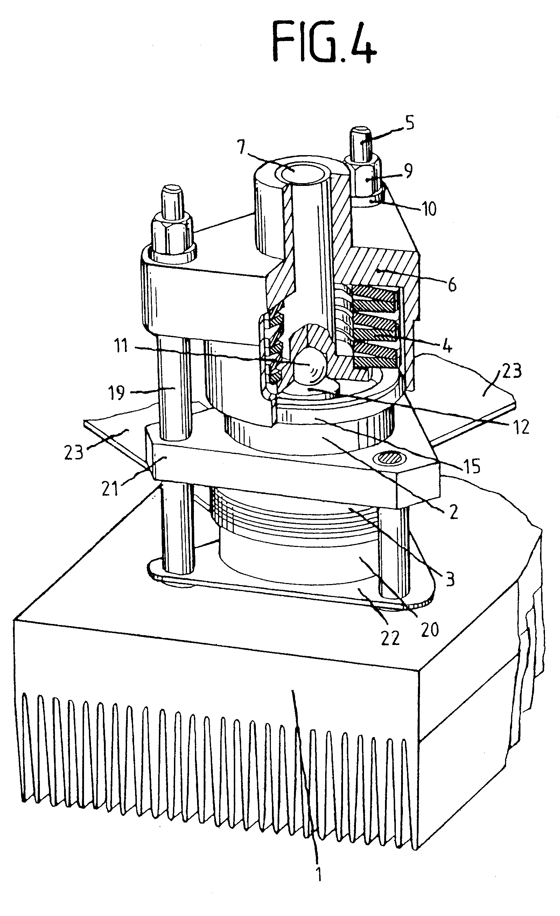

..Fig. 4    die Spannvorrichtung in perspektivischer Gesamtansicht.

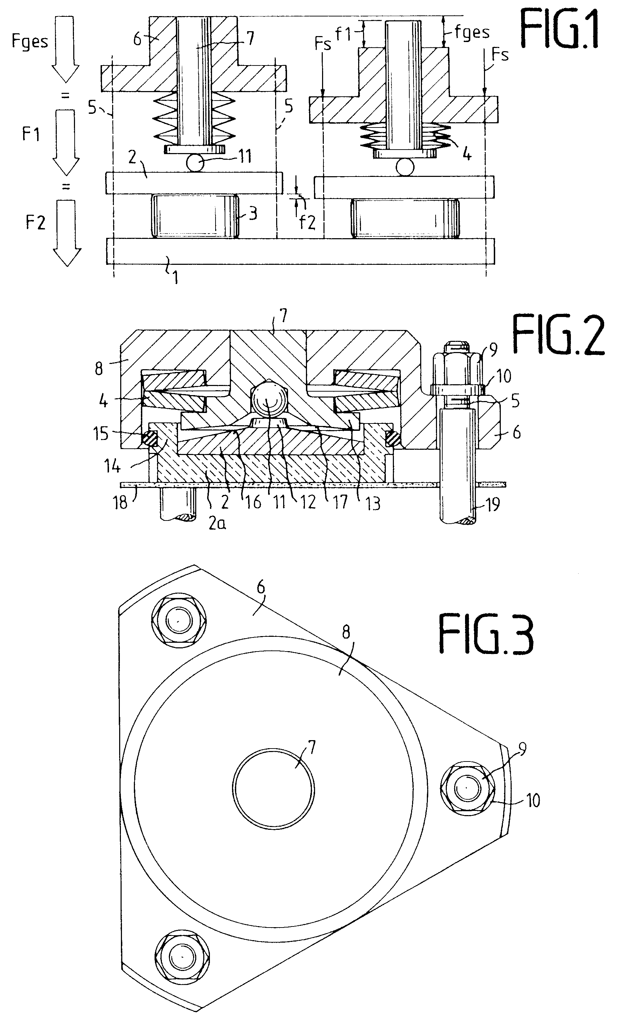

Nach dem Funktionsprinzip der Fig. 1 ist ein Scheibenzellenhalbleiter 3 (z.B. ein Thyristor) zwischen einer (Kühlplatte als) Grundplatte 1 und einer Druckplatte 2 angeordnet. In der linken Teilfigur ist die Scheibenzelle 3 noch lose eingelegt, die Tellerfeder (n) 4 ist/sind entlastet. In der rechten Teilfigur steht die Scheibenzelle unter Druck, die Tellerfedern 4 sind gespannt. Stehbolzen 5 (gestrichelt angedeutet) sind in der Grund- oder Kühlplatte 1 eingeschraubt. Sie durchdringen hier die Druckplatte 2 und die jetzt erfindungsgemäße Spannplatte 6. Über nicht näher dargestellte aufgesetzte Muttern kann eine Kraft Fs auf die Spannplatte 6 ausgeübt werden.

Diese Kraft kann auch durch andere Verspannmittel als Stehbolzen, z.B. durch Schrauben oder Außenverklammerungen aufgebracht werden. Damit erfolgt eine Vertikalbewegung der Spannplatte 6 unter Vorspannung der Tellerfedern 4, die sich einerseits an der Spannplatte 6 und andererseits auf einem in der Spannplatte 6 axial verschiebbar gelagerten Stempel 7 abstützen. Die tatsächlich durch die Tellerfedern 4 ausgeübte kontaktgebende Kraft ist im wesentlichen - bei bekannter Federkonstante - durch den Federweg der Tellerfedern 4 gegeben, der durch das Maß f1 des beim Verspannen heraustretenden Anteils des Stempels 7 ablesbar wird. An sich fließt bei der Ermittlung der tatsächlich ausgeübten kontaktgebenden Kraft auch der Federweg f2 des als Feder anzusehenden Scheibenzellenhalbleiters bzw. seines Stapelaufbaus wirksam mit ein. Der Federweg f2 ist bei der Kraftermittlung jedoch nicht von Bedeutung, da er durch die Reihenschaltung die gleiche Kraft beinhaltet. Es gilt somit

$$Fges = f1 = f2 = .... fn.$$

Die Fig. 2 und 3 zeigen eine reale Ausführungsform einer Spannplatteneinheit in geschnittener Ansicht und Draufsicht. Die eigentliche Spannplatte hat dabei die Form eines gleichseitigen Dreiecks mit einem äußeren angeformten zentralen Zylinderteil 8, in dem der durchgehende Stempel 7 axial verschiebbar gelagert ist. Durch die drei Flanschecken der Spannplatte 6 ragen die Stehbolzen 5, die jeweils von Isolierhülsen 19 umgeben sind.

Die Kraft wird, wie bisher, mit Hilfe der auf den Stehbolzen 5 befindlichen Muttern 9 aufgebracht. Im Unterschied dazu kann jedoch auf die Verwendung eines Drehmomentenschlüsse verzichtet werden, da das aufgebrachte Drehmoment nicht als Hilfsgröße zur Kraftermittlung verwendet wird.

Die von den Muttern 9 aufgebrachte Kraft wird zunächst auf die biegesteife Spannplatte 6 übertragen, in der der Stempel 7 axial verschiebbar gelagert ist und sich über die Tellerfedern 4 gegen die Spannplatte 6 abstützt. Über die Vorspannung der Tellerfedern 4 wird letztlich die Druckplatte 2 beaufschlagt. Die ausgeübte Kraft wird über eine im Stempel 7 geführte Kugel 11, die auf einer Wendeschneidplatte 12 mit Schieflagen gestattenden Freiflächen 16 aufliegt, in die Druckplatte 2 eingeleitet. Die Kugel 11 hat einen relativ kleinen Durchmesser oder Radius und kann bei Schieflage von Spannplatte 6 und Stempel 7 frei und reibungsarm abrollen. Durch den kleingewählten Radius ist die beim Anrollen auftretende Exzentrizität vernachlässigbar klein und hat keinen negativen Einfluß auf eine gleichmäßige Krafteinleitung.

Kostengünstig ist die Verwendung einer genormten Kugellagerkugel und einer Wendeschneidplatte 12 aus Hartmetall, die zentral auf der Druckplatte 2 festgelegt ist, z.B. durch Kleben oder Löten. Die Spannplatte 6 weist auf der Innenseite eine abgestufte zylindrische Ausdrehung auf, in der die Tellerfedern 4 einliegen und sich andererseits auf einen flanschartigen Fuß 13 des Stempels 7 abstützen, der eine untere der konvexen Freifläche 16 der Druckplatte 2 angepaßte konkave Freifläche 17 aufweist. Die Druckplatte 2 ist in einer Isolierschale 2a eingebettet, die mit ihrem umlaufenden Bord 14 über einen äußeren Dichtungsring 15 (O-Ring) in der inneren zylindrischen Ausdrehung der Spannplatte 6 einliegt. Mit 18 ist noch eine Isolierplatte bezeichnet.

Da die Tellerfedern 4 konstruktionsbedingt auch nicht bei Schieflage der Spannplatte 6 exzentrische belastet werden und die Federkennlinie definiert und bekannt ist, stellt das Maß der Relativbewegung zwischen Stempel und Spannplatte ein Äquivalent für die tatsächliche aufgebrachte Kraft dar. Auf diese Weise ist eine Entkopplung der für die Krafterzeugung relevanten Federbewegung von dem Federverhalten des Gesamtsystems erreicht. Eine Kontrolle der Federkraft über die Wegmessung ist denkbar einfach und bedarf weder mechanischer noch elektrischer Zusatzeinrichtungen. Die Wegmessung erfolgt als Differenzmessung zwischen Stempel 7 und Spannplatte 6 sowohl im entspannten als auch gespannten Zustand der Tellerfedern 4. Die Spannvorrichtung kann so ausgelegt werden, daß bei Erreichen der gewünschten Spannkraft, die Oberseiten des Stempels 7 und des zentralen Zylinderteils 8 der Spannplatte 6 eine Planfläche bilden, was auch mit dem bloßen Auge zu erkennen ist. Eine entsprechend gewählte Federkennlinie sorgt bei minimaler Verschiebung, z.B. infolge eines Beobachtungsfehlers, für nur einen vernachlässigbar kleinen Fehler der Spannkraft.

Fig. 4 zeigt in einem Gesamtüberblick eine andere Ausführungsform der Spannvorrichtung in perspektivischer Ansicht. Ein Scheibenhalbleiter 3 (Thyristor) ist mit einer Isolierzelle 20 und Anschlußfahnen 23 über eine massive Isolationsplatte 21 verspannt, auf der die Druckplatte 2 aufliegt. Die Druckplatte ist in diesem Fall nicht von den Stehbolzen 5 mit Isolierrohr 19 durchdrungen, sondern liegt auf der dreieckförmigen Isolierplatte 21 auf, die ihrerseits von den drei Stehbolzen durchdrungen und geführt wird. Mit 22 ist noch eine Halteplatte bezeichnet, im übrigen wird Bezug auf schon zitierte Bezugszeichen genommen.

**Patentansprüche**

1. Spannvorrichtung für Scheibenzellenhalbleiter, insbesondere Scheibenzellen-Leistungshalbleiter, bei der ein oder mehrere Halbleiter, speziell bei Stapelaufbauten mit anderen Komponenten, zwischen eine Grundplatte und eine Druckplatte eingespannt werden, wobei die Klemmkraft zwischen Grundplatte und Druckplatte insbesondere über mehrere an der Peripherie der Platten angeordnete Stehbolzen mit endseitiger Verschraubung erzeugt und über zwischengeschaltete mitverspannte federnde Elemente der eigentliche Kontaktdruck bewirkt wird, **dadurch gekennzeichnet,** daß die Halbleiter direkt zwischen Grundplatte (1) und Druckplatte (2) angeordnet sind und die Kraftübertragung von der Grundplatte (1) über die Stehbolzen (5) zur Druckplatte (2) mittels einer zusätzlichen Spannplatte (6) erfolgt, die von den Stehbolzen (5) durchdrungen wird und einen in Kraftwirkungsrichtung axial verschiebbaren Stempel (7) aufweist, der sich einerseits über die federnden Elemente gegen die Spannplatte (6) abstützt und andererseits die über die Bolzenverschraubung (5/9) ausgeübte Kraft an die Druckplatte (2) weitergibt.

2. Spannvorrichtung nach Anspruch 1, **dadurch gekennzeichnet,** daß die Spannplatte (6) die Form eines gleichseitigen Dreiecks aufweist, mit eckseitigen Löchern für die Stehbolzen (5) und einem angeformten zentralen Zylinderteil (8), in dem der Stempel (7) gleitend gelagert ist.

3. Spannvorrichtung nach Anspruch 1 oder 2, **dadurch gekennzeichnet,**
daß die Spannplatte (6) eine durch den zentralen Zylinderteil (8) führende axiale Bohrung kleineren Durchmessers für die Führung und Lagerung des Stempels (7) aufweist und auf der der Druckplatte (2) zugewandten Seite mit einer dazu koaxialen Ausdrehung größeren Durchmessers für die Aufnahme von Tellerfedern (4) als federnde Elemente versehen ist.

4. Spannvorrichtung nach den Ansprüchen 1 bis 3, **dadurch gekennzeichnet,** daß der Stempel (7) einen flanschartigen Fuß (13) aufweist, der innerhalb der Ausdrehung der Spannplatte (6) positioniert als Anstützung für die Tellerfedern (4) dient.

5. Spannvorrichtung nach den Ansprüchen 1 bis 4 **dadurch gekennzeichnet,** daß der Stempel (7) die ausgeübte Kraft der Tellerfedern (4) über ein zentrisches Krafteinleitungselement, das im Stempel (7) geführt ist, in die Druckplatte (2) einleitet.

6. Spannvorrichtung nach Anspruch 5, **dadurch gekennzeichnet,** daß als Krafteinleitungselement eine Kugellagerkugel (7) Verwendung findet, die auf einer harten Gegenfläche auf der Druckplatte (2) aufliegt.

7. Spannvorrichtung nach Anspruch 6, **dadurch gekennzeichnet,** daß als harte Gegenfläche eine Wendeschneidplatte (12) aus Hartmetall Verwendung findet.

8. Spannvorrichtung nach Anspruch 7, **dadurch gekennzeichnet,** daß die Wendeschneidplatte (12) auf der Druckplatte (2) zentral festgelegt ist.

9. Spannvorrichtung nach einem der vorhergehenden Ansprüche, **dadurch gekennzeichnet,** daß über das Maß (f1) des beim Verspannen sich verschiebenden Stempels (7) und der Federkonstante der Tellerfeder (4) der Kontaktdruck kontrolliert einstellbar ist.

10. Spannvorrichtung nach einem der vorhergehenden Ansprüche, **dadurch gekennzeichnet,** daß eine Differenzwegmessung zwischen Stempel (7) und der Spannplatte (6) sowohl im entspannten als auch gespannten Zustand vorgenommen wird und aus der Differenz beider Meßwerte die Kraft ableitbar ist.

11. Spannvorrichtung nach Anspruch 10, **dadurch gekennzeichnet,** daß die Auslegung so getroffen ist, daß bei Erreichen der gewünschten Spannkraft, die Oberseiten des Stempels (7) und des Zylinderteils (8) eine Planfläche bilden.

FIG.1

FIG.2

FIG.3

# FIG.4

Europäisches
Patentamt

**EUROPÄISCHER RECHERCHENBERICHT**

Nummer der Anmeldung

EP 95 25 0166

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-3 812 557 (EATON) <br> * Anspruch 1; Abbildung 1 * <br> --- | 1 | H01L23/40 |
| A | GB-A-2 042 803 (ALSTHOM) <br> * Abbildungen 1,2 * <br> --- | 1 | |
| A | EP-A-0 035 135 (SEMIKRON) <br> * Abbildung 1 * <br> --- | 1,3 | |
| A | US-A-3 571 663 (CHEMETRON) <br> --- | | |
| A | US-A-3 755 719 (ELECTRIC REGULATOR) <br> ----- | | |
| | | | **RECHERCHIERTE SACHGEBIETE (Int.Cl.6)** |
| | | | H01L |

Der vorliegende Recherchenbericht wurde für alle Patentansprüche erstellt

| Recherchenort | Abschlußdatum der Recherche | Prüfer |
|---|---|---|
| DEN HAAG | 20. September 1995 | De Raeve, R |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
 
& : Mitglied der gleichen Patentfamilie, übereinstimmendes
    Dokument

EPO FORM 1503 03.82 (P04C03)